(19) Europäisches Patentamt
European Patent Office
Office européen des brevets

(11) **EP 4 667 631 A1**

(12) **EUROPEAN PATENT APPLICATION**
published in accordance with Art. 153(4) EPC

(43) Date of publication:
**24.12.2025 Bulletin 2025/52**

(21) Application number: 23922923.0

(22) Date of filing: **12.12.2023**

(51) International Patent Classification (IPC):
*D03D 15/267* (2021.01)    *C08J 5/24* (2006.01)
*D03D 1/00* (2006.01)    *D06M 13/513* (2006.01)
*H05K 1/03* (2006.01)

(52) Cooperative Patent Classification (CPC):
**C08J 5/24; D03D 1/00; D03D 15/267;
D06M 13/513; H05K 1/03**

(86) International application number:
**PCT/JP2023/044392**

(87) International publication number:
**WO 2024/171590 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.02.2023 JP 2023023775**

(71) Applicant: **Asahi Kasei Kabushiki Kaisha
Tokyo 1000006 (JP)**

(72) Inventors:
• **HIROSE, Amane
Tokyo 100-0006 (JP)**
• **HASHIMOTO, Yuka
Tokyo 100-0006 (JP)**

(74) Representative: **Hoffmann Eitle
Patent- und Rechtsanwälte PartmbB
Arabellastraße 30
81925 München (DE)**

(54) **GLASS CLOTH, PREPREG, AND PRINTED WIRING BOARD**

(57) The purpose of the present disclosure is to provide: a quartz glass cloth which comprises glass yarns having a high silicon dioxide ($SiO_2$) content and has such a property that a laminated body thereof can be improved in insulation reliability; and a prepreg, a printed wiring board and others, each containing the quartz glass cloth. The present disclosure provides a glass cloth which is configured using, as warps and wefts, glass yarns each comprising a plurality of filaments. The silicon (Si) content in the glass yarns is 95.0 wt% to 100 wt% in terms of silicon dioxide ($SiO_2$) content, and the average single filament diameter (D) of the filaments is in the range of 4.5 $\mu$m to 9.0 $\mu$m. The relationship between the thickness (T) of the glass cloth and the average single filament diameter (D) of the filaments satisfies the formula: $24.0 \times D - T > 96.0$. The product ($\mu$m·$cm^3/cm^2$/s) of the thickness of the glass cloth and the air permeability of the glass cloth is in the range of 2500 to 6000.

**Description**

FIELD

The present disclosure relates to a glass fabric, a prepreg, a printed circuit board, and the like. The present international application claims the priority based on Japanese Patent Application No. 2023-023775 filed on February 17, 2023, and the entire content of the Japanese Patent Application is incorporated in the present international application.

BACKGROUND

Currently, information terminals such as smartphones are increasingly higher in performance, and communication typified by 5G communication is increasingly higher in speed. In view of such circumstances, in particular, printed circuit boards for high-speed communication are desired to achieve not only an enhancement in heat resistance which has been conventionally required, but also further enhancements in dielectric characteristics (for example, lowered dielectric tangent) of insulation materials thereof. Similarly, prepregs used in insulation materials for printed circuit boards, glass fabrics included in the prepregs, and glass yarns constituting the glass fabrics are also desired to achieve enhancements in dielectric characteristics.

PTLs 1 and 2 describe constitution of an insulation material with a prepreg in which a glass fabric is impregnated with a dielectric resin as a matrix resin, for the purpose of a reduction in dielectric constant of such an insulation material. PTLs 1 and 2 describe polyphenylene ether having an end modified by a vinyl group or a methacryloxy group, which is advantageous for low dielectric characteristics and heat resistance, and use of such modified polyphenylene ether as a matrix resin.

PTL 3 describes enhancements in dielectric characteristics of a prepreg and a printed circuit board with a glass fabric having a compositional amount of $SiO_2$ of 98 wt% to 100 wt%.

Printed circuit boards are demanded to have not only dielectric characteristics, but also insulation reliability. Various methods are known in order to suppress the occurrence of conductors called conductive anode filaments (CAF: an abbreviation of Conductive Anodic Filaments), as one mode of insulation failures of printed circuit boards. For example, PTL 4 describes a method for enhancing insulation reliability of a printed circuit board by removal of alkali metal and alkali earth metal compounds on a glass fabric surface. PTL 5 describes a procedure for suppressing the occurrence of CAF by decrease of aggregation of a modified phenol compound and smoothening of inner walls of through-holes.

[CITATION LIST]

[PATENT LITERATURE]

[PTL 1] International Publication No. WO2019/065940
[PTL 2] International Publication No. WO2019/065941
[PTL 3] Japanese Unexamined Patent Publication (Kokai) No. 2021-63320
[PTL 4] Japanese Unexamined Patent Publication (Kokai) No. 2005-42245
[PTL 5] Japanese Unexamined Patent Publication (Kokai) No. 2006-63114

SUMMARY

[TECHNICAL PROBLEM]

The present inventors have made studies, and as a result, have found that, when quartz glass having a high silicon dioxide ($SiO_2$) content is used for conventional glass fabrics as described in PTLs 1 to 4, stacked products obtained from such conventional glass fabrics have room for further improvement in terms of insulation reliability.

An object of the present disclosure is to provide a quartz glass fabric which is constituted from a glass yarn having a high silicon dioxide ($SiO_2$) content and which can enhance insulation reliability of a stacked product, and a prepreg, a printed circuit board and the like each comprising the quartz glass fabric.

[SOLUTION TO PROBLEM]

Some of aspects of the present disclosure are exemplified in the following Items [1] to [17].

[1] A glass fabric constituted from a warp yarn and a weft yarn, which are a glass yarn including a plurality of filaments, wherein the glass yarn has a silicon (Si) content of from 95.0 wt% to 100 wt% in terms of silicon dioxide ($SiO_2$), the filaments have an average single filament diameter (D) in a range of 4.5 $\mu$m to 9.0 $\mu$m, and a relationship between a thickness (T) of the glass fabric and the average single filament diameter (D) of the filaments satisfies the following formula (A1):

$$24.0 \times D - T > 96.0 \dots (A1);$$

and wherein a product of the thickness and air permeability of the glass fabric ($\mu$m·$cm^3$/$cm^2$/s) is in a range of 2500 to 6000.

[2] The glass fabric according to Item 1, wherein, when the glass fabric is immersed in a desmear solution and subjected to a surface treatment at 80°C for 2 hours, a rate of decrease in desmear of the average single filament diameter (D) of the filaments, represented by the following formula, is 25% or less:

Rate of decrease in desmear = (Single filament diameter before desmear treatment - Single filament diameter after desmear treatment)/Single filament diameter before desmear treatment $\times$ 100.

[3] The glass fabric according to Item 1 or 2, wherein the glass fabric has air permeability in a range of 25 $cm^3$/$cm^2$/s to 350 $cm^3$/$cm^2$/s.

[4] The glass fabric according to any one of Items 1 to 3, wherein the glass yarn is subjected to a surface treatment with a surface treatment agent.

[5] The glass fabric according to Item 4, wherein the surface treatment agent has a silane coupling agent having a structure represented by the following general formula (1):

$$X(R)_{3-n}SiY_n \dots \qquad (1)$$

in the formula (1), X is an organic group having one or more unsaturated double bond groups having radical reactivity, Y is each independently an alkoxy group, n is an integer of 1 to 3, and R is each independently at least one group selected from the group consisting of a methyl group, an ethyl group, and a phenyl group.

[6] The glass fabric according to Item 5, wherein X in the general formula (1) has a (meth)acryloyloxy group.

[7] The glass fabric according to any one of Items 1 to 6, wherein the glass fabric has a value of loss of ignition in a range of 0.01 wt% to 0.50 wt%.

[8] The glass fabric according to any one of Items 1 to 7, wherein the average number of filaments in the glass yarn is in a range of 20 to 200.

[9] The glass fabric according to any one of Items 1 to 8, wherein a coefficient of variation in total amount of carbon, as obtained with gas chromatography of the glass fabric, is in a range of 15% or less.

[10] The glass fabric according to any one of Items 1 to 9, wherein a nitrogen content, as obtained with gas chromatography of the glass fabric, is less than 0.004 wt%.

[11] A prepreg containing the glass fabric according to any one of Items 1 to 10, and a matrix resin with which the glass fabric is impregnated.

[12] The prepreg according to Item 11, further containing an inorganic filler.

[13] A printed circuit board comprising the prepreg according to Item 11.

[14] An integrated circuit comprising the printed circuit board according to Item 13.

[15] An electronic device comprising the printed circuit board according to Item 13.

[16] A method for producing a glass fabric, the method comprising:

a process of weaving a glass yarn including a plurality of filaments and having a Si content in a range of 95.0 wt% to 100 wt% in terms of $SiO_2$, as each of a warp yarn and a weft yarn, to obtain a glass fabric, wherein the method further comprises, before the weaving process, a warping process of flattening and then sizing a yarn bundle of the glass yarn; and wherein the method further comprises, after the warping process and before, during or after the weaving process, the following:

washing the glass yarn with water at 50°C or more;
heating/de-oiling and decreasing a binder attached to the glass yarn; and
irradiating the glass yarn heated/de-oiled, with ultrasound in a liquid, to open at least some of the glass filaments adhering by a residue of the binder after heating/de-oiling,

wherein the filaments have an average single filament diameter (D) in a range of 4.5 $\mu$m to 9.0 $\mu$m, and a relationship between a thickness (T) of the glass fabric and the average single filament diameter (D) of the filaments satisfies the following formula (A1):

$$24.0 \times D - T > 96.0 \dots (A1).$$

[17] The method according to Item 16, further comprising:

a surface treatment process of performing an operation including attaching a surface treatment agent to a surface of the filament-opened glass fabric and fixing the surface treatment agent to the surface of the glass fabric by heating and drying; and
opening at least some of the glass filaments adhering by the surface treatment agent.

[ADVANTAGEOUS EFFECTS OF INVENTION]

The present disclosure can provide a quartz glass fabric which is constituted from a glass yarn having a high silicon dioxide ($SiO_2$) content and which can enhance insulation reliability of a stacked product, and a prepreg, a printed circuit board and the like each comprising the quartz glass fabric.

DESCRIPTION OF EMBODIMENTS

Hereinafter, embodiments of the present disclosure are described, but the present disclosure is not limited thereto and can be various modified without departing from the gist thereof.

In the present disclosure, a numerical value range described with "to" represents a numerical value range including numerical values before and after "to" respectively as the lower limit value and the upper limit value. The upper limit value or the lower limit value described with a certain numerical value range as a numerical value range described stepwise can be replaced with the upper limit value or the lower limit value of any other numerical value range described stepwise. Furthermore, the upper limit value or the lower limit value described with a certain numerical value range can also be replaced with any value shown in Examples. The term "process" includes not only an independent process, but also any process not clearly distinguishable from other processes as long as such any process can achieve the function of the relevant process.

<<Glass Fabric>>

The glass fabric of the present disclosure is a glass fabric which includes a glass yarn including a plurality of filaments, as each of a warp yarn and a weft yarn. The silicon (Si) content in the glass yarn is 95.0 wt% or more and 100 wt% or less in terms of silicon dioxide ($SiO_2$), the average single filament diameter (D) of the filaments is in a range of 4.5 $\mu$m or more and 9.0 $\mu$m or less, and the relationship between the thickness (T) of the glass fabric the average single filament diameter (D) of the filaments satisfies the following formula (A1).

$$24.0 \times D - T > 96.0 \dots (A1)$$

The product of the thickness ($\mu$m) and the air permeability of the glass fabric ($cm^3/cm^2/s$) is in a range of 2500 to 6000 ($\mu$m·($cm^3/cm^2/s$)).

Conventional glass fabrics as described in PTLs 1 and 2 have not been considered in terms of use of low-dielectric glass, and have room for further improvement in terms of dielectric characteristics. In this regard, PTL 3 describes improvements in dielectric characteristics of a prepreg and a printed circuit plate by use of a glass fabric including glass filaments having a high compositional amount of $SiO_2$, but it has been found as a result of studies by the present inventors that there is room for further improvement in terms of insulation reliability of a printed circuit plate.

Examples of an improvement of a glass fabric for the purpose of an enhancement in insulation reliability (hereinafter, also referred to as "CAF resistance".) include an improvement of an opening filament process of a glass fabric, as described in PTL 4. However, it has been found as a result of studies by the present inventors that quartz glass is high in hardness as compared with glass other than quartz glass and therefore CAF resistance is difficult to sufficiently improve by a conventional filament-opening treatment described in PTL 4 in the case of use of a glass fabric constituted from a quartz glass yarn.

On the contrary, the present disclosure can provide a quartz glass fabric allowing for an enhancement in insulation reliability of a stacked product, and a prepreg, a printed circuit board and the like each comprising the quartz glass fabric. Without limitations on the theory and any particular production method, the product of the thickness and the air permeability of the glass fabric can be adjusted in a predetermined range by using, as a glass yarn, quartz glass where the average single filament diameter (D) relative to the thickness (T) of the glass fabric satisfies a predetermined relationship and releasing adhesion between filaments due to a residue of a binder, to provide processing so that higher filament-opening than conventional one is achieved. The product of the thickness and the air permeability of the glass fabric with, as a glass yarn, quartz glass where the average single filament diameter (D) relative to the thickness (T) of the glass fabric satisfies a predetermined relationship is in a predetermined range, and thus a glass fabric excellent in CAF resistance can be provided, as described below in detail.

[Glass Yarn]

The glass yarn constituting the glass fabric can be obtained with quartz glass as a raw material. Specifically, the Si content in the glass yarn is in a range of 95.0 wt% to 100 wt% in terms of $SiO_2$, more preferably 99.0 wt% to 100 wt%, further preferably 99.5 wt% to 100 wt%, particularly preferably 99.9 wt% to 100 wt%. Use of such a glass yarn can allow for enhancements in dielectric characteristics and CAF resistance of the resulting glass fabric.

The average single filament diameter of the glass filaments constituting the glass yarn is 4.5 $\mu$m to 9.0 $\mu$m, more preferably 5.0 $\mu$m to 9.0 $\mu$m, further preferably 5.5 $\mu$m to 8.5 $\mu$m, still further preferably 5.8 $\mu$m to 8.2 $\mu$m, particularly preferably 6.0 $\mu$m to 8.0 $\mu$m. When the average single filament diameter is equal to or more than the lower limit value, rupture strength of the filaments is increased and therefore fuzz in the resulting glass fabric can be suppressed. When the average single filament diameter is equal to or less than the upper limit value, cracking (cutting) against bending deformation of the glass yarn is hardly caused and the mass productivity in production of the glass fabric is enhanced. When the average single filament diameter of the glass filaments is in the above range, the product of the thickness and the air permeability, and the rate of decrease in desmear are easily adjusted in predetermined ranges, and the effect of enhancement of CAF resistance is easily obtained.

The average number of filaments as glass filaments constituting the glass yarn is preferably in a range of 20 to 200. The upper limit value of the average number of filaments is more preferably 180 or less, still further preferably 160 or less, particularly preferably 150 or less, 140 or less, 130 or less, 120 or less, 110 or less, or 100 or less. The lower limit value arbitrarily combined with such an upper limit value is more preferably 30 or more, further preferably 35 or more, particularly preferably 40 or more, or 45 or more. When the average number of filaments is equal to or more than the lower limit value, cutting of the glass yarn hardly occurs, and fuzz is hardly caused in the resulting glass fabric. When the average number of filaments is equal to or less than the upper limit value, adhesion between filaments due to a binder residue is easily released, the glass yarn is easily filament-opened, and a desmear solution hardly penetrates into a glass yarn bundle, and therefore a glass fabric excellent in CAF resistance is easily obtained. Accordingly, when the average number of filaments is in the above range, the effect with CAF resistance is easily obtained.

[Woven Structure and the like]

The glass fabric is constituted with the glass yarn (for example, glass yarn made of a plurality of glass filaments), as each of the warp yarn and the weft yarn. Examples of the woven structure of the glass fabric include woven structures such as plain-woven, basket-woven, sateen-woven, and twilled structures. In particular, a plain-woven structure is preferred.

The beating densities of the warp yarn and the weft yarn constituting the glass fabric are each independently preferably 10 yarns/inch to 120 yarns/inch (= 10 to 120/25.4 mm), more preferably 40 yarns/inch to 100 yarns/inch. When the beating densities are in the above ranges, the product of the thickness and the air permeability is easily adjusted in a predetermined range and the effect with CAF resistance is easily obtained.

The basis weight of the glass fabric (the weight of the glass fabric) is preferably 8 g/m$^2$ to 250 g/m$^2$ , more preferably 8 g/m$^2$ to 100 g/m$^2$, further preferably 8 g/m$^2$ to 80 g/m$^2$, particularly preferably 8 g/m$^2$ to 50 g/m$^2$. When the basis weight of the glass fabric is in the above range, the product of the thickness and the air permeability, and the rate of decrease in desmear are easily adjusted in predetermined ranges, and the effect with CAF resistance is easily obtained.

[Surface Treatment Agent]

The glass yarn in the glass fabric is preferably subjected to a surface treatment with a surface treatment agent from the viewpoint of an enhancement in adhesiveness to a resin used in a prepreg. **In** the present disclosure, both a case where glass filaments are subjected to a surface treatment in the course of glass fabric production and a case where the glass fabric is subjected to a surface treatment are included in a concept where "the glass yarn is subjected to a surface treatment with a surface treatment agent". The glass yarn can be subjected to a surface treatment with, for example, a titanate-based coupling agent or a silane coupling agent. The surface treatment agent preferably contains a silane coupling agent from the viewpoint of easy modification by a suited functional group with respect to each resin of a prepreg.

The silane coupling agent preferably has a structure represented by the following general formula (1):

$$X(R)_{3-n}SiY_n \ldots \qquad (1)$$

in the formula (1), X is an organic group having one or more unsaturated double bond groups having radical reactivity, Y is each independently an alkoxy group, n is an integer of 1 to 3, and R is each independently at least one group selected from the group consisting of a methyl group, an ethyl group, and a phenyl group.

The glass fabric is subjected to a surface treatment with the silane coupling agent of the general formula (1), resulting in a tendency to enhance insulation reliability and heat resistance of a printed circuit board.

X in the molecule structure of the silane coupling agent of the general formula (1) preferably has a (meth) acryloyloxy group. X is more preferably a (meth)acryloyloxy group not containing an amino group. A silane coupling agent containing an extremely trace amount of an amino group-containing component or not containing an amino group is high in hydrophobicity. The glass yarn as quartz glass is subjected to a surface treatment with such a silane coupling agent high in hydrophobicity, thereby allowing for suppression of peeling at an interface between the resulting glass fabric and a matrix resin and as a result, an enhancement in CAF resistance. A method for evaluating whether or not the silane coupling agent contains an amino group is not particularly limited, and a method with gas chromatography is known. Whether or not the silane coupling agent has an amino group can be determined by measurement of the amount of nitrogen dioxide generated by thermal decomposition, with gas chromatography. Specifically, when the nitrogen content per weight of the glass fabric is less than 0.004 wt%, it is determined that the silane coupling agent does not have an amino group. The nitrogen content is more preferably less than 0.0035, further preferably less than 0.003, particularly preferably less than 0.0025. The nitrogen content per weight of the glass fabric may be 0 wt% or more, or more than 0 wt%. However, when an extremely trace amount of an amino group-containing component is contained in or the component is not contained in the silane coupling agent, the "content of the amino group-containing component in the silane coupling agent", or the "nitrogen content per weight of the glass fabric" can also be derived as a minus value due to distribution or the like of the baseline, depending on the measurement procedure. Here, this case also corresponds to a gist where the nitrogen content per weight of the glass fabric is a slight content, and thus is encompassed in a scope of "0 wt% or more and less than 0.004 wt%" or "more than 0 wt% and less than 0.004 wt%".

X in the general formula (1) preferably does not contain an amino group. For example, X in the general formula (1) preferably does not contain an amine such as a primary amine, a secondary amine or a tertiary amine, or an ammonium cation such as a quaternary ammonium cation. Thus, the amount of the silane coupling agent chemically bound with the glass yarn surface can be suitably controlled and CAF resistance of the glass fabric can be more enhanced.

At least one of Ys plurally present in the general formula (1) is preferably an alkoxy group having 1 to 5 carbon atoms (having 1, 2, 3, 4 or 5 carbon atoms) for the purpose of a stable treatment of the glass fabric. Half or more, or all of Ys plurally present are each more preferably an alkoxy group having 1 or more and 5 or fewer carbon atoms.

The silane coupling agent represented by the general formula (1) may be used singly or in combination of two or more kinds thereof. For example, two or more of such silane coupling agents different in X in the general formula (1) from each other may be used in combination, or two or more of such silane coupling agents different in R in the general formula (1) from each other may be used in combination.

The content of the silane coupling agent represented by the general formula (1) in the surface treatment agent for the surface treatment of the glass yarn is preferably 95.0 wt% to 100 wt%, more preferably 96.5 wt% to 100 wt%, further preferably 98.0 wt% to 100 wt%, still further preferably 99.0 wt% to 100 wt%, particularly preferably 99.9 wt% to 100 wt%. Thus, various characteristics including CAF resistance of the resulting glass fabric are more enhanced. The silane coupling agent may include any other silane coupling agent (other silane coupling agent) than the silane coupling agent represented by the general formula (1), or may include any other component than the silane coupling agent.

The molecular weight of the silane coupling agent represented by the general formula (1) is preferably 100 to 600, more preferably 150 to 500, further preferably 200 to 450. In particular, as the silane coupling agent, a plurality of kinds of such silane coupling agents different in molecular weight falling within the above range is preferably used in combination. Thus, a plurality of different kinds of such silane coupling agents can be used to provide a suitable surface treatment of the glass yarn, and results in an increase in density of the silane coupling agent on the glass surface. Thus, reactivity with a matrix resin tends to be further enhanced. In the case of combination use of a plurality of kinds of such silane coupling agents different in molecular weight from each other, preferably, at least two of such silane coupling agents are silane coupling agents which are represented by the general formula (1) and whose molecular weights fall within the above range.

The silane coupling agent represented by the general formula (1) is preferably non-ionic. For example, X in the general formula (1) preferably has at least one group selected from the group consisting of a vinyl group and a (meth) acryloyloxy group, more preferably has a (meth)acryloyloxy group. Thus, suitable reactivity with a matrix resin can be ensured and heat resistance and reliability of a printed circuit board are easily increased. The (meth)acryloyloxy group here contains at least one of a methacryloyloxy group and an acryloyloxy group.

Examples of the silane coupling agent represented by the general formula (1) preferably include vinyltrimethoxysilane, 3-methacryloxypropyltrimethoxysilane, 5-hexenyltrimethoxysilane and acryloyloxypropyltrimethoxysilane. Such a silane coupling agent easily provides the effect with CAF resistance. Examples of the silane coupling agent represented by the general formula (1) include, in addition to the above, the following silane coupling agents.

[Table 1]

| X | Y | n | R |
|---|---|---|---|
| Vinyl group | having 1 to 5 carbon atoms | 1 | At least one of methyl group, ethyl group and phenyl group |
| Vinyl group | having 1 to 5 carbon atoms | 2 | At least one of methyl group, ethyl group and phenyl group |
| Vinyl group | having 1 to 5 carbon atoms | 3 | At least one of methyl group, ethyl group and phenyl group |
| Methacryloyloxy group | having 1 to 5 carbon atoms | 1 | At least one of methyl group, ethyl group and phenyl group |
| Methacryloyloxy group | having 1 to 5 carbon atoms | 2 | At least one of methyl group, ethyl group and phenyl group |
| Methacryloyloxy group | having 1 to 5 carbon atoms | 3 | At least one of methyl group, ethyl group and phenyl group |
| Acryloyloxy group | having 1 to 5 carbon atoms | 1 | At least one of methyl group, ethyl group and phenyl group |
| Acryloyloxy group | having 1 to 5 carbon atoms | 2 | At least one of methyl group, ethyl group and phenyl group |
| Acryloyloxy group | having 1 to 5 carbon atoms | 3 | At least one of methyl group, ethyl group and phenyl group |

[Value of Loss of Ignition]

The value of loss of ignition of the glass fabric is preferably in a range of 0.01 to 0.50 wt%. The upper limit value of the value of loss of ignition is more preferably in a range of 0.25 wt% or less, further preferably 0.20 wt% or less, still further preferably 0.18 wt% or less, particularly preferably 0.16 wt% or less, 0.15 wt% or less, 0.14 wt% or less, or 0.13 wt% or less. The lower limit value arbitrarily combined with such an upper limit value is more preferably 0.02 wt% or more, further preferably 0.03 wt% or more, still further preferably 0.04 wt% or more, particularly preferably 0.05 wt% or more. When the value of loss of ignition is equal to or less than the upper limit value, the amount of the surface treatment agent, for example, the silane coupling agent chemically bound with the glass yarn surface, is not too large, and the dielectric tangent of the glass fabric, and thus the dielectric tangent of the resulting printed circuit board is enhanced. **In** this regard, when the value of loss of ignition is equal to or more than the lower limit value, the amount of the surface treatment agent bound with the glass yarn surface is not too small, and heat resistance and insulation reliability of the resulting printed circuit board are enhanced.

As described above, low-dielectric glass is used as the glass yarn and the nitrogen content based on the total weight of the glass fabric is preferably less than 0.004 wt%. The lower limit value of the nitrogen content is not limited, and may be, for example, 0% or more, or more than 0%. **In** general, a high hardness of quartz glass easily causes the occurrence of brittle fracture in glass fabrics with quartz glass. However, the risk of brittle fracture can be decreased by not only favorable compatibility between quartz glass and the surface treatment agent for the surface treatment of the glass, low in nitrogen content, for example, the silane coupling agent, but also the value of loss of ignition of the glass fabric, falling within the above range.

[Coefficient of Variation in Total Amount of Carbon in Glass Fabric]

As described in Examples of the present disclosure, the total amount of carbon in the glass fabric, as obtained by an evaluation method with gas chromatography, is preferably 0.01 to 0.50 wt%. The upper limit value of the total amount of carbon in the glass fabric is more preferably 0.25 wt% or less, further preferably 0.20 wt% or less. The lower limit value arbitrarily combined with such an upper limit value is more preferably 0.03 wt% or more, still further preferably 0.04 wt% or more, particularly preferably 0.05 wt% or more. The total amount of carbon in the glass fabric reflects the amount of the surface treatment agent, for example, the silane coupling agent attached to the glass yarn, and as the amount of the surface treatment agent attached is larger, the total amount of carbon in the glass fabric is larger. The evaluation method with gas chromatography can be made with a test piece having a small area, and therefore is suitable for evaluation of the variation in amount of the surface treatment agent attached to the glass fabric. It is effective for an enhancement in CAF resistance of a printed circuit board to decrease a region in which the surface treatment agent on the glass yarn surface is not attached. The surface treatment agent is present throughout glass filaments of the glass fabric, thereby inhibiting such glass filaments from being dissolved during the desmear process, and therefore CAF resistance of a printed circuit board can be enhanced. **In** other words, as a region in which the surface treatment agent is not attached to the glass filament surface is decreased, the rate of decrease in desmear of the average single filament diameter of the glass filaments tends to be lowered.

The present inventors have found that the characteristic where the surface treatment agent is uniformly attached to glass filaments is effectively identified by the coefficient of variation in the total amount of carbon in the glass fabric. The total amount of carbon, as obtained with gas chromatography, tends to be larger in coefficient of variation thereof in a sample having a large region in which the surface treatment agent is not attached. Accordingly, in order to enhance CAF resistance of a printed circuit board, a glass fabric having a smaller coefficient of variation in the total amount of carbon in the glass fabric, after the surface treatment, is more preferred. The upper limit value of the range of the coefficient of variation in the total amount of carbon in the glass fabric is preferably 15% or less, more preferably 12% or less, further preferably 10% or less, still further preferably 8%, particularly preferably 6% or less. The lower limit value arbitrarily combined with such an upper limit value is not limited, and may be, for example, 0% or more, more than 0%, or 1% or more. When the coefficient of variation in the total amount of carbon in the glass fabric is 15% or less, the amount of the surface treatment agent attached to the glass yarn surface is made uniform, a region in which the surface treatment agent is not attached to the glass yarn is decreased, and the rate of decrease in desmear of the average single filament diameter of the glass filaments is lowered. The procedure for decreasing the coefficient of variation in the total amount of carbon in the glass fabric is effectively to perform the surface treatment process multiple times, as described below. The surface treatment process can be performed multiple times to decrease a region in which the surface treatment agent is not attached to the glass yarn surface.

[Relationship between Thickness of Glass Fabric and Average Single Filament Diameter of Glass Filaments]

The relationship between the thickness (T) of the glass fabric and the average single filament diameter (D) of filaments in the glass yarn in the glass fabric satisfies the following formula (A1), preferably satisfies the following formula (A2), further preferably satisfies the following formula (A3), still further preferably satisfies (A4), particularly preferably satisfies (A5).

$$24.0 \times D - T > 96.0 \ \ldots (A1)$$

$$24.0 \times D - T > 98.0 \ \ldots (A2)$$

$$24.0 \times D - T > 100.0 \ \ldots (A3)$$

$$24.0 \times D - T > 104.0 \ \ldots (A4)$$

$$24.0 \times D - T > 108.0 \ \ldots (A5)$$

The formula (A1) is satisfied to reduce the capillary force in the glass yarn bundle, and therefore, when a printed circuit board is treated with a desmear solution and a plating liquid, the liquids can be inhibited from penetrating into the glass yarn bundle. Thus, CAF resistance of a printed circuit board can be enhanced.

[Rate of Decrease in Desmear of Average Single Filament Diameter of Glass Filaments]

The rate of decrease in desmear of the average single filament diameter of the glass filaments in the glass fabric is preferably 25% or less. When the rate of decrease in desmear is equal to or less than the upper limit value, a desmear solution less damages the glass fabric during a desmear treatment of a printed circuit board and CAF resistance of a printed circuit board is enhanced. The rate of decrease in desmear is preferably 24% or less, more preferably 23% or less, further preferably 22% or less. The lower limit value of the rate of decrease in desmear, which can be combined with such an upper limit value, may be 0% or more, for example, more than 0%. The rate of decrease in desmear is measured by a method described in Examples of the present disclosure.

Without limitations on any particular production method, the rate of decrease in desmear of the average single filament diameter of the glass filaments in the glass fabric is more easily controlled by, for example, performing sizing processing (gluing) after flattening of the yarn bundle during warping, washing the glass fabric with water at a predetermined temperature or more before heating/de-oiling of the glass fabric, performing a filament-opening treatment in a period after heating/de-oiling and before a surface treatment, and performing a surface treatment of the glass fabric multiple times, in the method for producing the glass fabric described below.

[Air permeability of Glass Fabric]

The air permeability of the glass fabric is preferably in a range of 25 to 350 $cm^3/cm^2/s$, more preferably 30 to 330 $cm^3/cm^2/s$, further preferably 35 to 300 $cm^3/cm^2/s$, particularly preferably 40 to 250 $cm^3/cm^2/s$, 40 to 200 $cm^3/cm^2/s$, or 40 to 150 $cm^3/cm^2/s$. When the air permeability is equal to or less than the upper limit value, bubbles called voids hardly remain between glass filaments in a prepreg, and insulation failures in a printed circuit board are hardly caused. When the air permeability is equal to or more than the lower limit value, the inner wall of a drill hole is smoothened during drill hole formation in a printed circuit board, and insulation failures are hardly caused. The air permeability of the glass fabric can be adjusted by the filament-opening treatment process, and the air permeability of the glass fabric is more easily adjusted in the above range by a filament-opening treatment described below.

[Product of Thickness and Air Permeability of Glass Fabric]

The product of the thickness ($\mu$m) and the air permeability ($cm^3/cm^2/s$) of the glass fabric is in a range of 2500 to 6000. The product of the thickness and the air permeability is preferably in a range of 2800 to 5800, more preferably in a range of 2900 to 5600, further preferably in a range of 3000 to 5400, particularly preferably in a range of 3200 to 5200. In order that the relationship between the thickness (T) of the glass fabric and the average single filament diameter (D) of the filaments in the glass yarn satisfies the above formula (A1), it is important to uniformly open the filament of the yarn bundle with a glass yarn having a relatively large single filament diameter. Such a glass fabric, when insufficiently filament-opened, tends to have a large thickness and a high air permeability (namely, the product of the thickness and the air permeability is increased). A glass fabric in which the product of the thickness and the air permeability is more than 6000 easily causes bubbles called voids to remain between glass filaments in a prepreg and easily causes insulation failures of a printed circuit board. When the thickness of the glass fabric is large, drill friction easily occurs during drill hole formation, and the inner wall of a drill hole is easily roughened. The product of the thickness and the air permeability of the glass fabric which satisfies the above formula (A1) and which is sufficiently filament-opened is easily adjusted to 2500 or more, and CAF resistance of a printed circuit board is easily improved.

Without limitations on any particular production method, the product of the thickness and the air permeability of the glass fabric, and the rate of decrease in desmear of the average single filament diameter of the glass filaments are more easily controlled by, for example, performing sizing processing (gluing) after flattening of the yarn bundle during warping, washing the glass fabric with water at a predetermined temperature or more before heating/de-oiling of the glass fabric, performing a surface treatment of the glass fabric multiple times, and performing a filament-opening treatment in a period after heating/de-oiling and before the surface treatment, in the method for producing the glass fabric described below.

[Thickness of Glass Fabric]

The thickness of the glass fabric is preferably 10 to 100 $\mu$m. The upper limit value of the thickness of the glass fabric is preferably 80 $\mu$m or less, further preferably 60 $\mu$m or less, particularly preferably 50 $\mu$m or less from the viewpoint of easy control of filament-opening of the glass fabric. The lower limit value arbitrarily combined with such an upper limit value is preferably 15 $\mu$m or more, further preferably 20 $\mu$m or more, particularly preferably 30 $\mu$m or more from the viewpoint that handling during conveyance of the glass fabric is excellent.

<<Method for Producing Glass Fabric>>

The method for producing the glass fabric of the present disclosure comprises a process (weaving process: B) of weaving a glass yarn including a plurality of filaments and having a Si content in a range of 95.0 wt% to 100 wt% in terms of $SiO_2$, as each of a warp yarn and a weft yarn, to obtain a glass fabric. The method further comprises a warping process (A) of paralleling and flattening the glass yarn and then applying a sizing agent, before the weaving process, a process (washing process before heating/de-oiling: C) of washing the glass yarn before heating/de-oiling, with water at 50°C or more, after the warping process and before, during or after the weaving process, then a process (heating/de-oiling process: D) of heating/de-oiling and decreasing a binder attached to the glass yarn, and a process (washing/opening filament process: E) of filament-opening at least some of glass filaments adhering by a residue of the binder after heating/de-oiling. The method optionally has a surface treatment process (F) of uniformly coating the glass filaments with a surface treatment agent, and a process (G) of filament-opening at least some of glass filaments adhering by the surface treatment agent. Thus, a glass fabric, a prepreg and the like allowing for an enhancement in CAF resistance of a printed circuit board can be provided.

The glass treatment method (processes (C) to (G)) can be applied to a quartz glass yarn before weaving, and can also be applied to the glass fabric woven. In other words, the process of weaving the quartz glass yarn to obtain the glass fabric may be provided before, during or after the glass treatment method. Hereinafter, an aspect in which the processes (A) to (G) are included in the listed order is described as an example, but the method for producing the glass fabric of the present disclosure is not limited thereto.

[Warping Process (A) of Glass Yarn]

The warping process of a glass yarn includes a process of using a glass yarn having a Si content in a range of 95.0 wt% to 100 wt% in terms of $SiO_2$, flattening a yarn bundle thereof and then sizing the glass yarn. According to the treatment, gluing can be performed in a state where the yarn width is broadened, thereby facilitating the broadening of the yarn width in a state of the glass fabric after weaving and allowing for control so that the product of the thickness and the air permeability of the glass fabric satisfies a predetermined range. A method for flattening a glass yarn bundle is not particularly limited, and examples include a method such as a processing treatment under pressure with a roller. The pressure is preferably 1.0 kg/cm² to 6.0 kg/cm², more preferably 2.0 kg/cm² to 5.0 kg/cm², further preferably 2.5 kg/cm² to 5.5 kg/cm² from the viewpoint of not only suppression of fuzz, but also flattening of the yarn bundle. The warping process facilitates removal of a gluing agent in a subsequent washing process before heating/de-oiling.

[Weaving Process (B) of Glass Fabric Greige]

A preparation process of a glass fabric greige includes weaving a glass yarn including a plurality of filaments and having a Si content in a range of 95.0 wt% to 100 wt% in terms of $SiO_2$, as each of a warp yarn and a weft yarn. The glass yarn used in the process is a glass yarn having a filament diameter satisfying at least one of the formulae (A1) to (A3) relative to the thickness of the resulting glass fabric. Thus, a glass fabric greige can be prepared. The glass yarn is preferably subjected to a surface treatment with a sizing agent mainly containing starch, polyvinyl alcohol, or the like in order to suppress fuzz during the spinning and warping of the glass yarn. Such a treatment with the sizing agent may be performed during spinning of and at the same time as warping process of the glass yarn. The glass fabric greige is woven by weaving a weft yarn into the warp yarn obtained in the warping process. In the present disclosure, the "glass fabric greige" refers to a glass fabric before heating/de-oiling.

The glass yarn used in the processes (A) to (B) is a glass yarn having a filament diameter satisfying at least one of the formulae (A1) to (A5). Thus, CAF resistance of a printed circuit board can be enhanced.

[Washing Process (C) before Heating/De-sizing]

The washing process before heating/de-oiling includes a process of washing the glass fabric before heating/de-oiling, with water at 50°C or more, to decrease a gluing agent. Thus, adhesion by combustion residues of a gluing agent of filaments and a gluing agent during heating/de-oiling can be decreased, and control can be made so that the product of the thickness and the air permeability of the glass fabric satisfies a predetermined range. The solvent used for washing in the treatment is preferably water from the viewpoint of the washing efficiency, and the temperature is preferably 50°C or more. Use of water at 50°C or more not only allows a required amount of the gluing agent for protection of the glass yarn until the heating/de-oiling process to remain, but also can allow an excess gluing agent to be washed. The temperature of water is preferably 50°C or more and less than 100°C. The lower limit value of the temperature of water is more preferably 55°C or more, further preferably 60°C or more, still further preferably 65°C or more. The upper limit value of the temperature of water, which can be combined with such a lower limit value, is more preferably 95°C or less, further preferably 90°C or less. The solvent used for washing is not particularly limited, and washing with water, reverse osmosis (RO) water, ion-exchange water, or the like is preferred from the viewpoint of safety and cost. The method for washing the glass fabric greige is not particularly limited, and is considered to be, for example, a method such as a procedure with ultrasound (for example, procedure with an ultrasonic vibrator), atomization by spraying (for example, atomization by high-pressure spraying), or water vapor misting. A method including immersing the glass fabric greige in a tank in which a washing liquid is stored, then removing an excess washing liquid by a squeeze roller or the like, and thereafter drying the glass fabric greige is preferred from the viewpoint that processing can be inexpensively made. In this case, the immersion time may be, for example, 2 seconds or more, 5 seconds or more, 10 seconds or more, or 15 seconds or more, and 120 seconds or less, 90 seconds or less, 60 seconds or less, or 45 seconds or less.

[Process (D) of Decreasing Sizing Agent]

The process (D) of heating/de-oiling treatment of a binder to be attached to the glass fabric greige can have, for example, a de-sizing process (heating/de-oiling process) of heating the glass fabric greige at a temperature of 650°C to 1000°C. Thus, the binder is easily decreased from glass.

The glass fabric greige can be heated sequentially or continuously in a closed system or an open system, or can be heated with a combination of a closed system and an open system. A system in which the glass fabric greige is subjected to a heat treatment in a Roll-to-Roll manner with an apparatus having an unwinding mechanism and a winding mechanism is particularly preferred from the viewpoint of productivity.

In the case of a closed system, the glass fabric greige is preferably placed in a heating furnace from the viewpoint of a heating tool, and/or the glass fabric greige is preferably heated with being stored in the form of a wound product, from the viewpoint of a storage space and a heating range. The glass fabric greige is also preferably heated with being conveyed in a heating furnace from the viewpoint of an increase in removal efficiency of an organic substance and a decrease in removal time of an organic substance.

In the case of an open system, the glass fabric greige is preferably heated with being conveyed from the viewpoint of the area to be heated. The glass fabric greige can be conveyed with, for example, an unwinding mechanism and a winding mechanism.

(Heating Furnace)

The heating tool of the heating furnace is considered to be any of various tools such as an electrical heater and a burner, as long as heating can be made so that the surface temperature of the glass fabric greige is a temperature more than 650°C, and is not limited to only a particular tool. Heating may also be made with a combination of a plurality of tools, the glass fabric greige is preferably heated under an atmosphere having an oxygen concentration of 10% or more, and a gas-type single radiant tube burner or an electrical heater is preferably used therefor.

The heating furnace preferably includes a tool for emitting a gas generated in the heating furnace, and/or an air circulation tool from the viewpoint of the heating efficiency. The gas emission tool may be, for example, a nozzle, a gas tube, a small hole, or a degassing valve. The air circulation tool may be, for example, a fan or air-conditioning equipment.

In order to efficiently remove an organic substance attached to a glass fabric greige surface, a continuous system in which the glass fabric greige can be heated with continuously passing through the heating furnace is more preferred than a batch system in which a glass fiber woven fabric is wound around a core and the glass fabric greige is heated at a predetermined atmosphere temperature.

In order to sufficiently remove an organic substance attached to a glass fabric greige surface, the heating temperature, in terms of the surface temperature of the glass fabric greige, is preferably a temperature more than 650°C, more preferably 700°C or more, further preferably 750°C or more, particularly preferably 800°C or more. The surface temperature of the glass fabric greige can be measured with, for example, a thermocouple or a non-contact thermometer.

(Contact Member for Heating Glass Fabric Greige)

The heating furnace may be used in the method for heating the glass fabric greige, and the glass fabric greige may be heated by contacting a member heated to a predetermined temperature and the glass fabric greige, from the viewpoint of a low running cost.

The shape of the contact member is not particularly limited as long as heating can be made so that the surface temperature of the glass fabric greige is more than 650°C, and the shape is preferably a roller shape from the viewpoint of ease of conveyance of the glass fabric greige. The member which can have a roller shape to heat the glass fabric greige is preferably a roller which can be used in a high temperature region, which is relatively less varied in temperature in the width direction, and which provides warming in an induction heat generation system. When the glass fabric greige is heated with the contact member, the temperature of the contact member and the surface temperature of the glass fabric greige are considered to be substantially equal to each other.

In order to remove carbide attached to a heating roller as the glass fabric greige is continuously heated, the heating roller system is preferably a system including a mechanism for removal of grime and/or a foreign substance attached to the roller, for example, a mechanism such as a blade.

[Washing/Opening Filament Process (E) of Glass Fabric]

The glass fabric of the present disclosure can be obtained by preferably a process (E) of filament-opening the glass fabric after heating/de-oiling, at a position where glass filaments adhere to each other by a residue of the binder. The process (E) of filament-opening preferably includes an opening filament process of irradiating the glass fabric with ultrasound in a liquid to perform filament-opening.

The glass fabric can be subjected to a filament-opening treatment after heating/de-oiling, to have an impact on a binder residue present between glass filaments, thereby consequently allowing for release of adhesion between glass filaments. It is preferable for effective release of adhesion between glass filaments to not perform the filament-opening treatment after surface treatment, but perform the filament-opening treatment in a period after heating/de-oiling and before the surface treatment. Since adhesion between glass filaments is released by performing a sufficient filament-opening treatment before a surface treatment, each of such glass filaments can be coated with a surface treatment agent, and a glass fabric and a prepreg which are excellent in CAF resistance can be provided.

The opening filament process after heating/de-oiling may further include, in addition to the process of irradiating the glass fabric with ultrasound in a liquid to perform filament-opening, another opening filament process in a process. Examples of such another opening filament method include a method including immersing the glass fabric in a liquid, a method including immersing the glass fabric in a liquid and applying force to the glass fabric through the liquid (for example, a vibrowasher method or an ultrasonic method), and a method including vigorously spraying a liquid to the glass fabric (for example, a high-pressure spraying method). The glass fabric can also be immersed in the form of a wound product in a liquid and thus filament-opened, or a system in which the glass fabric is filament-opened with being conveyed in a Roll-to-Roll manner, by use of an apparatus having an unwinding mechanism and a winding mechanism, is preferred from the viewpoint of productivity.

The liquid used for filament-opening can be any of water or an organic solvent, and is preferably a liquid mainly containing water, from the viewpoint of safety and global environment protection. A surfactant or a pH adjuster can also be added to the liquid used for washing, in order to increase the efficiency of filament-opening.

The temperature of the liquid used for filament-opening is not particularly restricted, and is preferably 5°C or more from the viewpoint of an enhancement in effect. The temperature of the liquid used for filament-opening is preferably 60°C or less from the viewpoint of safety.

It is preferable to remove a binder residue after heating/de-oiling as much as possible and then perform a surface treatment process, and therefore a method including filament-opening the glass fabric by irradiation of the glass fabric with ultrasound in water is preferably used from the viewpoint of an enhancement in washing force.

The glass fabric can be traveled in a liquid being irradiated with ultrasound by an ultrasonic oscillator, and thus the glass fabric can be irradiated with ultrasound and filament-opened in the liquid. The line tension acting on the warp yarn in the opening filament process is preferably 30 N to 500 N/1 m in glass fabric width. When the line tension acting on the warp yarn is 30 N/1 m or more in glass fabric width, uniform stretching is made without loosening of the glass fabric and relaxing of the warp yarn, and therefore filament-opening by ultrasound can be allowed to act without any variation.

The filament-opening with ultrasound irradiation can be made with ultrasound having a frequency of 20 kHz or more and 200 kHz or less. The frequency of ultrasound is preferably 20 kHz or more and 50 kHz or less, more preferably 20 kHz or more and 30 kHz or less. Such ultrasound having a frequency of 20 kHz or more and 200 kHz or less is preferably used because a filament-opening treatment can be performed without any large defect such as bowed filling of the glass fabric.

In ultrasonic washing, ultrasound having an output of 0.07 W/cm$^2$ or more and 3.60 W/cm$^2$ or less can be preferably used. A more preferred range of the output of ultrasound is 0.14 W/cm$^2$ or more and 2.16 W/cm$^2$ or less, and a further preferred range thereof is 0.21 W/cm$^2$ or more and 1.44 W/cm$^2$ or less. An output of ultrasound of 0.07 W/cm$^2$ or more is preferred because favorable filament-opening can be performed, and an output of ultrasound of 3.60 W/cm$^2$ or less is preferred because the occurrence of bowed filling or the like is not caused and uniform filament-opening can be performed.

A preferred ultrasound treatment time is 0.5 seconds or more and 60 seconds or less. An ultrasound treatment time of 0.5 seconds or more is preferred because the glass fabric or an intermediate thereof can be favorably filament-opened. The ultrasound treatment time is more preferably longer because a large filament-opening effect is obtained, but further filament-opening almost does not occur even by a treatment over an ultrasound treatment time of more than 60 seconds and therefore a sufficient ultrasound treatment time is 60 seconds.

While air mainly containing nitrogen and oxygen is usually dissolved in the liquid used for an ultrasonic washing treatment, the amount of dissolved oxygen (weight ratio) is preferably 1 ppm or more and 20 ppm or less, a more preferred range is 3 ppm or more and 17 ppm or less, and a further preferred range is 4 ppm or more and 14 ppm or less. The amount of dissolved oxygen can be regulated to allow for indirect control of the amount of dissolved gas and allow for control of the degree of attenuation of ultrasound due to the dissolved gas. An amount of dissolved oxygen of 1 ppm or more is preferred because a filament-opening treatment is uniformly applied. An amount of dissolved oxygen of 20 ppm or less is preferred because favorable filament-opening action is imparted to a fiber fabric. An amount of dissolved oxygen in a range of 1 ppm or more and 20 ppm or less is preferred because a uniform and favorable filament-opening effect is obtained.

[Surface Treatment Process (F) of Glass Fabric]

A surface treatment process (F) of uniformly coating the glass filaments with a surface treatment agent is carried out by, for example, performing an operation including attaching a surface treatment agent to a glass fabric surface and heating and drying the resultant to fix the surface treatment agent to the glass fabric surface, multiple times. Thus, each of the glass filaments is easily coated with the surface treatment agent, and a glass fabric and a prepreg which are excellent in CAF resistance can be provided. In order to decrease a surface treatment agent which cannot be decreased by water, for example, a residual material and a modified product of the silane coupling agent, washing with an organic solvent high in hydrophobicity, or washing with an organic solvent high in affinity with a residual material and a modified product of a hydroxyl group-containing silane coupling agent (finish washing process) is carried out after a fixing process, thereby suitably easily surface-treating the glass fabric.

Each of the filaments can be more uniformly coated with a surface treatment agent than a conventional case, by releasing adhesion between filaments with a filament-opening treatment after heating/de-oiling and performing a surface treatment of the glass fabric multiple times. The surface treatment agent serves to chemically bind the glass fabric and a matrix resin in a prepreg, and therefore a glass fabric with a filament surface more uniformly subjected to a surface treatment can more allow a glass fabric and a prepreg which are excellent in CAF resistance to be provided.

Examples of the method for attaching the surface treatment agent include a method including coating the glass fabric with a treatment solution containing the surface treatment agent or a method including immersing the glass fabric in a treatment solution. The method for coating glass with a treatment solution in the surface treatment process can be, for example, (a) a method including immersing glass in a treatment solution stored in a bath or allowing the glass to pass through the treatment solution (hereinafter, referred to as "immersion method".), or (b) a method including coating glass with a treatment solution by a roll coater, a die coater, a gravure coater or the like. When the immersion method is adopted, the immersion time of the glass in the treatment solution is preferably selected to be 0.5 seconds or more and 1 minute or less. After the glass is coated with the treatment solution, a solvent included in the treatment solution can be heated and dried by a method with hot air, electromagnetic waves, or the like. A method including removing an excess treatment solution by squeezing of the glass fabric with a squeezing roller or the like after immersion in the treatment solution is preferred from the viewpoint that the amount of the treatment solution attached is easily controlled.

The concentration of the surface treatment agent included in the treatment solution is preferably 0.05 wt% to 0.4 wt%, more preferably 0.07 wt% to 0.35 wt%, further preferably 0.09 wt% to 0.3 wt%. Thus, glass is more suitably easily subjected to a surface treatment.

The heating and drying temperature in the fixing process of the surface treatment agent is preferably 80°C or more, more preferably 90°C or more so that reaction of the surface treatment agent, for example, the silane coupling agent with the glass is sufficiently performed. The heating and drying temperature is preferably 300°C or less, more preferably 180°C or less in order to prevent degradation of the organic group in the surface treatment agent, for example, the silane coupling agent.

The treatment solution may be repelled on the glass surface in a period until the glass fabric is heated and dried after immersion of the glass fabric in the treatment solution and then squeezing by a squeezing roller, and thus an extremely small amount of the surface treatment agent is attached or the surface treatment agent is not attached at the relevant position, in some cases. Accordingly, the covering process and the fixing process are preferably carried out multiple times, for example, two to five times from the viewpoint of uniform surface treatment processing performed. The covering process and the fixing process are preferably carried out two to three times from the viewpoint that both productivity and uniform surface treatment processing of the glass surface are achieved.

The method for removing the residual material and the modified product of the silane coupling agent in the finish washing process can be a known method such as an immersion method or shower atomization, and warming or cooling may be, if necessary, performed. In order not to again attach a product attached to the glass fabric, which is here dissolved, an excess solvent in the glass fabric after washing is preferably decreased by a squeezing roller or the like, before finish drying. The organic solvent used here is not particularly limited, and examples of the organic solvent high in hydrophobicity include

saturated linear aliphatic hydrocarbons such as n-pentane, i-pentane, n-hexane, i-hexane, n-heptane, i-heptane, n-octane, i-octane, 2,2,4-trimethylpentane (isooctane), n-nonane, i-nonane, n-decane, i-decane, and 2,2,4,6,6-pentamethylheptane (isododecane);
saturated cyclic aliphatic hydrocarbons such as cyclopentane, cyclohexane, methylcyclohexane, dimethylcyclohexane, and ethylcyclohexane;
aromatic hydrocarbons such as benzene, toluene, xylene, ethylbenzene, diethylbenzene, trimethylbenzene, and triethylbenzene;

halogen-containing solvents such as chloroform, dichloromethane, and dichloroethane. Examples of the organic solvent high in affinity with the modified product of the silane coupling agent include alcohols such as methanol, ethanol, and butanol, ketones such as acetone and methyl ethyl ketone, and ethers such as methyl ethyl ether and diethyl ether;

amides such as N,N-dimethylformamide and N,N-dimethylacetamide; and

dimethylsulfoxide. In particular, aromatic hydrocarbons, alcohols, or ketones are preferred, and methanol is more preferred, from the viewpoint of allowing the dielectric tangent of the resulting glass fabric to be closer to the bulk dielectric tangent. Accordingly, the washing liquid used in the finish washing process is preferably a washing liquid mainly containing methanol (50 wt% or more, or 60 wt% or more of methanol based on 100 wt% of the washing liquid).

In the finish drying process, the washing liquid used in the finish washing process can be decreased. The washing liquid used in the finish washing process preferably has a boiling point of 120°C or less in terms of ease of decrease of the washing liquid by drying. A method of drying by heating or drying by blowing can be adopted for the drying. When the organic solvent is used in the washing liquid, heating and drying are preferably performed by hot air drying with, as a heat source, low-pressure steam, heat medium oil or the like, from the viewpoint of safety. The drying temperature is preferably equal to or more than the boiling point of the washing liquid, and is preferably 180°C or less from the viewpoint of suppression of degradation of the silane coupling agent.

[Opening Filament Process (G) after Surface Treatment]

A opening filament process (G) of filament-opening at least some of glass filaments adhering by the surface treatment agent is preferably performed. For example, a method for filament-opening processing of the glass fabric by spray water (high-pressure water filament-opening), a vibrowasher, ultrasonic water, a mangle, or the like can be adopted as the opening filament process (G). The tension applied to the glass fabric during this filament-opening processing is decreased to result in a tendency to enable the air permeability to be more lowered. It is here preferable for suppression of a reduction in tensile strength of the glass fabric due to the filament-opening processing to take measures such as a reduction in friction with the contact member during glass yarn weaving, and optimization of a binding agent and an increase in amount of attachment of the binding agent.

The process described above do not necessarily need to be performed as separate processes, and a plurality of the processes can also be collectively performed as one process. For example, the washing process, when performed after the weaving process, can also serve as the opening filament process by use of a high-pressure water spray or the like in the washing process. The composition of the glass fabric is not usually changed before and after filament-opening in many cases. The method for producing the glass fabric can also have any process other than the above processes. For example, the method can have a slit-machining process after the opening filament process. If possible, the order of the processes can be interchanged.

According to the method for producing the glass fabric as described above, the glass surface can be uniformly coated with the surface treatment agent after release of adhesion between glass filaments, and a glass fabric, a prepreg and the like which are excellent in CAF resistance can be provided.

<<Prepreg>>

The prepreg of the present disclosure contains the glass fabric of the present disclosure, and a matrix resin with which the glass fabric is impregnated. Thus, a prepreg with few voids can be provided.

A thermosetting resin or a thermoplastic resin can be used as the matrix resin. If possible, both the resins may be used in combination, or any other resin may be further contained.

Examples of the thermosetting resin include

(a) an epoxy resin obtained by reacting and curing a compound having an epoxy group, and a compound having at least one group selected from the group consisting of an amino group, a phenol group, an acid anhydride group, a hydrazide group, an isocyanate group, a cyanate group and a hydroxyl group reactive with the epoxy group;

(b) a radical-polymerization cured resin obtained by curing a compound having at least one group selected from the group consisting of an allyl group, a methacrylic group, and an acrylic group;

(c) a maleimide-triazine resin obtained by curing a compound having a cyanate group and a compound having a maleimide group;

(d) a thermosetting polyimide resin obtained by reacting and curing a maleimide compound and an amine compound; and

(e) a benzoxazine resin obtained by crosslinking and curing a compound having a benzoxazine ring, by heating polymerization.

When the epoxy resin (a) is obtained, the compounds can be reacted with no catalyst, or the compounds can also be reacted with addition of a catalyst having reaction catalytic ability, such as an imidazole compound, a tertiary amine compound, a urea compound, and a phosphorus compound. When the radical-polymerization cured resin (b) is obtained, a thermal decomposition type catalyst or an optical decomposition type catalyst can be used as a reaction initiator.

Examples of the thermoplastic resin include polyphenylene ether, modified polyphenylene ether, polyphenylene sulfide, polysulfone, polyether sulfone, polyarylate, aromatic polyamide, polyetheretherketone, thermoplastic polyimide, insoluble polyimide, polyamide imide, and a fluororesin. The insulation material of a printed circuit board for high-speed communication is preferably polyphenylene ether or modified polyphenylene ether rich in radical reactivity.

When the matrix resin used in a printed circuit board for high-speed communication has a vinyl group or a methacrylic group, a silane coupling agent having a hydrocarbon group which is relatively high in hydrophobicity and which involves in radical reaction of a methacrylic group or the like is good in compatibility with the matrix resin.

As described above, the thermosetting resin and the thermoplastic resin can be used in combination. The prepreg can further contain an inorganic filler. The inorganic filler is preferably used in combination with the thermosetting resin, and examples thereof include aluminum hydroxide, zirconium oxide, calcium carbonate, alumina, mica, aluminum carbonate, magnesium silicate, aluminum silicate, silica, talc, a short glass fiber, aluminum borate, and silicon carbide. The inorganic filler may be used singly or in combination of two or more kinds thereof.

<<Printed Circuit Board>>

The printed circuit board of the present disclosure contains one or a plurality of the prepregs. Thus, a printed circuit board excellent in insulation reliability can be provided.

<<Integrated Circuit and Electronic Device>>

According to the present disclosure, an integrated circuit and an electronic device each comprising the printed circuit board are also provided. An integrated circuit and an electronic device each obtained with the printed circuit board of the present disclosure are excellent in various characteristics.

EXAMPLES

Hereinafter, Examples and Comparative Examples of the present disclosure are described in detail, but the present disclosure is not limited by the following Examples and Comparative Examples.

<<Measurement Method>>

[Measurement Methods of Value of Loss of Ignition and Air Permeability of Glass Fabric]

The value of loss of ignition and the air permeability of the glass fabric were determined according to JIS R3420.

[Evaluation Method of Thickness of Glass Fabric]

A spindle was gently rotated and lightly contacted in parallel with a measurement surface to read the scale after sounding by a ratchet three times, with a micrometer, according to 7.10 in JIS R3420.

[Product of Thickness and Air Permeability of Glass Fabric]

The product was calculated from the thickness and the air permeability of the glass fabric, determined by the above methods.

Product of thickness and air permeability of glass fabric = Thickness of glass fabric ($\mu$m) $\times$ air permeability of glass fabric ($cm^3/cm^2/s$)

[Coefficient of Variation in Total Amount of Carbon in Glass Fabric]

The glass fabric subjected to a surface treatment was cut out so that the weight was 80 to 100 mg. The glass fabric cut out was heated at about 800°C for 1 minute, and the amount of carbon dioxide in the gas generated was measured by gas chromatography, to determine the amount of carbon dioxide in the gas generated. The amount of carbon dioxide generated in similar heating of a predetermined amount of acetanilide ($C_8H_9NO$) at about 800°C for 1 minute in advance was adopted as a comparative subject, to determine the total amount of carbon per weight of the glass fabric subjected to a surface treatment. SUMIGRAPH NC-TR22 (manufactured by Sumika Chemical Analysis Service, Ltd.) was used for measurement.

> Molecular weight of acetanilide = 135.17
> Proportion of carbon in acetanilide = 71.09%

Specifically, the total amount of carbon per weight of the glass fabric was calculated based on the following formula.

Total amount of carbon per weight of glass fabric = [{Weight of acetanilide × (Proportion of carbon in acetanilide/100)}/Peak area assigned to carbon dioxide generated from acetanilide] × {(Peak area assigned to carbon dioxide generated from glass fabric/Weight of glass fabric) × 100}

This operation was performed at 10 positions in total with a cutting-out position of the glass fabric being varied, and the total amount of carbon was measured at each of the positions, to determine the average value and the standard deviation. The coefficient of variation in the total amount of carbon in the glass fabric was determined according to the following formula.

Coefficient (%) of variation in total amount of carbon in glass fabric = Standard deviation of total amount of carbon/ Average value of total amount of carbon × 100

[Measurement Method of Nitrogen Content]

The glass fabric subjected to a surface treatment was cut out so that the weight was 80 to 100 mg. The glass fabric cut out was heated at about 800°C for 1 minute, and the amount of nitrogen dioxide in the gas generated was measured by gas chromatography, to determine the amount of nitrogen dioxide in the gas generated. The amount of nitrogen dioxide generated in similar heating of a predetermined amount of acetanilide ($C_8H_9NO$) at about 800°C for 1 minute in advance was adopted as a comparative subject, to determine the nitrogen content ( wt%) per weight of the glass fabric, in the glass fabric subjected to a surface treatment. SUMIGRAPH NC-TR22 (manufactured by Sumika Chemical Analysis Service, Ltd.) was used for measurement.

> Molecular weight of acetanilide = 135.17
> Proportion of nitrogen in acetanilide = 10.36%

Specifically, the nitrogen content per weight of the glass fabric was calculated based on the following formula.

Nitrogen content per weight of glass fabric = [{Weight of acetanilide × (Proportion of nitrogen in acetanilide/100) }/ Peak area assigned to nitrogen dioxide generated from acetanilide] × {(Peak area assigned to nitrogen dioxide generated from glass fabric/Weight of glass fabric) × 100}

[Rate of Decrease in Desmear of Glass Filaments]

A swelling solution and a desmear solution were each prepared with stirring at room temperature according to the following formulation described in Table 2 below.

[Table 2]

| | Preparation composition (mL/L) | |
|---|---|---|
| | Chemical name | Composition |
| Swelling solution | Melplate (registered trademark) MLB alkaline solution manufactured by Meltex Inc. | 50 |
| | Melplate (registered trademark) MLB-6001B manufactured by Meltex Inc. | 150 |
| | Ion-exchange water | Balance |

(continued)

| | Preparation composition (mL/L) | |
|---|---|---|
| | Chemical name | Composition |
| Desmear solution | Melplate (registered trademark) MLB alkaline solution manufactured by Meltex Inc. | 80 |
| | Melplate (registered trademark) MLB oxidizer manufactured by Meltex Inc. | 100 |
| | Ion-exchange water | Balance |

A desmear treatment of the glass fabric was performed by the following procedure. Here, the "after desmear treatment" means a state after a treatment performed by immersion in each of the swelling solution and the desmear solution, and the "before desmear treatment" means a state before a treatment by immersion in the swelling solution.

(1) The glass fabric was cut out to 4-cm square. The resulting glass fabric was placed in a container made of perfluoroalkoxyalkane (PFA), and the swelling solution was added until the glass fabric was immersed.
(2) The container was lidded so that the swelling solution was not evaporated, and then heated at 80°C for 2 hours. The glass fabric completely treated with the swelling solution was sufficiently washed with ion-exchange water, and then dried.
(3) The glass fabric obtained in the operation (2) was again placed in the container made of PFA, and the desmear solution was added until the glass fabric was immersed.
(4) The container was lidded so that the desmear solution was not evaporated, and then heated at 80°C for 2 hours. The glass fabric completely treated with the desmear solution was sufficiently washed with ion-exchange water, and then dried, to complete the desmear treatment of the glass fabric.
(5) The respective average diameters of glass filaments constituting the glass fabric, before the desmear treatment and after the desmear treatment, were observed for 20 glass filaments with a microscope (HRX-1 manufactured by HIROX CO., LTD.), to determine the average single filament diameter of the glass filaments.
(6) The rate of decrease in desmear was calculated from the resulting single filament diameters before and after the desmear treatment, according to the following formula.

Rate of decrease in desmear = (Single filament diameter before desmear treatment - Single filament diameter after desmear treatment)/Single filament diameter before desmear treatment $\times$ 100

<<Production Examples>>

(Example 1)

Warp yarn warping (process (A)) was performed with a silica glass yarn having a compositional amount of $SiO_2$ of more than 99.9 wt% and having an average filament diameter of 7.5 $\mu$m, a number of filaments of 44, and a number of twists of 1.0 Z. The warp yarn paralleled at a conveying speed of 60 m/min was nipped with a roller under a load of 3.0 kg/cm², to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a glass fabric greige at a thread count of 66 warp yarns/inch and 68 weft yarns/inch (process (B)). The weft yarn used here was a silica glass yarn having an average filament diameter of 7.5 $\mu$m, a number of filaments of 44, and a number of twists of 1.0 Z.
While the glass fabric greige obtained was conveyed at a line speed so as to be immersed for 15 seconds in a water tank with ion-exchange water at 60°C stored, the sizing agent attached to a glass surface was washed (process (C)). Thereafter, a heating/de-oiling treatment was performed by heating in a heating furnace provided on the same line, under the air atmosphere, with a Roll-to-Roll system at 1000°C for 30 seconds (process (D)). The glass fabric after heating/de-oiling was subjected to continuous processing with the opening filament process (E) after heating/de-oiling, the surface treatment process (F), and the opening filament process (G) after surface treatment, provided on the same line. The processing here was performed at a line speed set to 20 m/min and a conveyance tension of the glass fabric, set to 200 N. In the opening filament process (E) after heating/de-oiling, the glass fabric, with being traveled in water, was irradiated with ultrasound at a frequency of 25 GHz and an output of 0.72 W/cm², and then heated and dried at 130°C for 30 seconds, to release adhesion between filaments. Subsequently, in the surface treatment process (F), the glass fabric was immersed in a treatment solution in which 0.3 wt% of 3-methacryloyloxypropyltrimethoxysilane; Z6030 (manufactured by Dow Toray Co., Ltd.) was dispersed in pure water adjusted to a pH of 3 with acetic acid, and squeezed and then dried at 125°C for 30 seconds. A series of processing, including the immersion, squeezing, and drying, was performed twice, to uniformly coat glass filaments with a surface treatment agent. Subsequently, in the opening filament process (G) after surface treatment, the glass fabric was subjected to filament-opening processing with column-like flow discharged from a 1.4-MPa high-pressure water spray, and then dried at 130°C for 30 seconds, to obtain the glass fabric.

(Example 2)

Warp yarn warping (A) was performed with a silica glass yarn having a compositional amount of $SiO_2$ of more than 99.9 wt% and having an average filament diameter of 7.5 $\mu$m, a number of filaments of 89, and a number of twists of 1.0 Z. The warp yarn paralleled at a conveying speed of 60 m/min was nipped with a roller under a load of 3.5 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 54 warp yarns/inch and 54 weft yarns/inch. The weft yarn used here was a silica glass yarn having an average filament diameter of 7.5 $\mu$m, a number of filaments of 89, and a number of twists of 1.0 Z. The glass fabric was processed by the same method as in Example 1 except that the glass fabric greige obtained was processed at a conveyance tension of 300 N.

(Example 3)

Warp yarn warping (A) was performed with a silica glass yarn having a compositional amount of $SiO_2$ of more than 99.9 wt% and having an average filament diameter of 6.0 $\mu$m, a number of filaments of 22, and a number of twists of 0.6 Z. The warp yarn paralleled at a conveying speed of 60 m/min was nipped with a roller under a load of 3.0 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 95 warp yarns/inch and 95 weft yarns/inch. The weft yarn used here was a silica glass yarn having an average filament diameter of 6.0 $\mu$m, a number of filaments of 22, and a number of twists of 0.6 Z. The glass fabric was processed by the same method as in Example 1 except that the glass fabric greige obtained was processed at a conveyance tension of 100 N.

(Example 4)

The glass fabric was processed by the same method as in Example 1 except that a silica glass yarn having an average single filament diameter 6.0 $\mu$m, a number of filaments of 69, and a number of twists of 1.0 Z was used as each of the warp yarn and the weft yarn.

(Example 5)

The glass fabric was processed by the same method as in Example 4 except that the series of processing, including the immersion, squeezing and drying, in the surface treatment process (F) was performed only once.

(Example 6)

The glass fabric was processed by the same method as in Example 1 except that a silica glass yarn having an average single filament diameter 5.7 $\mu$m, a number of filaments of 78, and a number of twists of 1.0 Z was used as each of the warp yarn and the weft yarn.

(Comparative Example 1)

The glass fabric was processed by the same method as in Example 1 except that a silica glass yarn having an average single filament diameter 5.0 $\mu$m, a number of filaments of 100, and a number of twists of 1.0 Z was used as each of the warp yarn and the weft yarn and the opening filament process (E) after heating/de-oiling was not performed.

(Comparative Example 2)

The glass fabric was processed by the same method as in Example 2 except that a silica glass yarn having an average single filament diameter 5.0 μm, a number of filaments of 200, and a number of twists of 1.0 Z was used as each of the warp yarn and the weft yarn and the opening filament process (E) after heating/de-oiling was not performed.

(Comparative Example 3)

The glass fabric was processed by the same method as in Comparative Example 1 except that the opening filament process (E) after heating/de-oiling was performed.

(Comparative Example 4)

The glass fabric was processed by the same method as in Example 1 except that the opening filament process (E) after heating/de-oiling was not performed.

(Comparative Example 5)

The glass fabric was processed by the same method as in Comparative Example 4 except that the surface treatment process (F) was performed once.

(Comparative Example 6)

The glass fabric was processed by the same method as in Example 1 except that nipping was not performed in the warp yarn warping (A).

(Comparative Example 7)

The glass fabric was processed by the same method as in Example 1 except that the sizing agent washing (C) was not performed.

(Comparative Example 8)

The glass fabric was processed by the same method as in Comparative Example 4 except that E glass (compositional amount of $SiO_2$: 55 wt%) was used as the glass yarn.

<<Evaluation Method>>

[Evaluation Method of Insulation Reliability (CAF Resistance) of Stacked Plate]

To 210 parts by weight of toluene was added 9 parts by weight of Tuftec H1041 (registered trademark, hydrogenated styrene-based thermoplastic elastomer, manufactured by Asahi Kasei Corporation), and stirred and dissolved. Next, SAYTEX8010 (registered trademark, ethylenebis(pentabromophenyl), manufactured by Albemarle Corporation), spherical silica SC2500-SVJ (registered trademark, manufactured by Admatechs), and Noryl SA9000 (trade name, polyphenylene ether, manufactured by SABIC) were added respectively in amounts of 24.5 parts by weight, 66 parts by weight, and 80 parts by weight, and continued to be stirred until dissolution of Noryl SA9000. Next, TAIC (registered trademark, triallyl isocyanurate, manufactured by Mitsubishi Chemical Corporation), and Perbutyl P (registered trademark, α,α'-di(t-butylperoxy)diisopropylbenzene, manufactured by NOF Corporation) were added respectively in amounts of 20 parts by weight and 0.5 parts by weight, and the mixture was sufficiently stirred, to obtain a varnish. The glass fabric obtained in each of Examples and Comparative Examples was impregnated with the varnish, and then dried at 115°C for 1 minute, and then a prepreg was obtained. Such prepregs obtained were stacked, copper foil having a thickness of 12 μm was stacked on and under a stacked product of such prepregs, and the resultant was heated and pressurized at 200°C and 40 kg/cm$^2$ for 120 minutes, to obtain a stacked plate having a thickness of 1.0 mm. A wiring pattern where through-holes were placed at an interval of 0.30 mm was produced on the copper foil on each of both surfaces of the stacked plate obtained, to obtain a specimen for insulation reliability evaluation. A voltage of 50 V was applied to the specimen obtained, under an atmosphere at a temperature of 85°C and a humidity of 85% RH, and the change in resistivity value was measured. A case where the resistivity reached less than 1 MΩ within 500 hours after the start of testing was counted as "insulation failure". Ten specimens were measured in the same manner, and the number of specimens where any insulation failure was observed, among the 10 specimens, was determined.

Production conditions and evaluation results in Examples and Comparative Examples are shown in Tables 3 and 4.

[Table 3]

Table 3

| | | | | Example 1 | Example 2 | Example 3 | Example 4 | Example 5 | Example 6 |
|---|---|---|---|---|---|---|---|---|---|
| Glass yarn | Compositional amount of $SiO_2$ | - | % | > 99.9 | > 99.9 | >99.9 | > 99.9 | > 99.9 | > 99.9 |
| | Single filament diameter (D) | Warp yarn | μm | 7.5 | 7.5 | 6.0 | 6.0 | 6.0 | 5.7 |
| | | Weft yarn | μm | 7.5 | 7.5 | 6.0 | 6.0 | 6.0 | 5.7 |
| | Number of filaments | Warp yarn | filaments | 44 | 89 | 22 | 69 | 69 | 78 |
| | | Weft yarn | filaments | 44 | 89 | 22 | 69 | 69 | 78 |
| Glass fabric | Thread count | Warp | filaments/inch | 66 | 54 | 95 | 66 | 66 | 66 |
| | | Weft | filaments/inch | 68 | 54 | 95 | 68 | 68 | 68 |
| | Value of loss of ignition | - | % | 0.11 | 0.10 | 0.18 | 0.09 | 0.07 | 0.09 |
| | Total amount of carbon | | % by weight | 0.10 | 0.09 | 0.17 | 0.08 | 0.07 | 0.08 |
| | Coefficient of variation in total amount of carbon | | % | 4 | 4 | 4 | 4 | 9 | 4 |
| | Nitrogen content | - | % by weight | < 0.004 | < 0.004 | < 0.004 | < 0.004 | < 0.004 | < 0.004 |
| | Air permeability | - | $cm^3/cm^2/sec$ | 140 | 70 | 331 | 100 | 100 | 91 |
| | Thickness (T) | - | μm | 30 | 46 | 15 | 30 | 30 | 30 |
| | Thickness × Air permeability | - | $cm^3/cm^2/sec × μm$ | 4200 | 3220 | 4965 | 3000 | 3000 | 2730 |
| | 24.0 × D-T | - | μm | 150 | 134 | 129 | 114 | 114 | 106.8 |
| | Rate of decrease in desmear | - | % | 11 | 11 | 22 | 22 | 24 | 22 |
| Warping process (A) | Nip pressure | - | $kg/cm^2$ | 3.0 | 3.5 | 3.0 | 3.0 | 3.0 | 3.0 |
| Washing process (C) before hea-ting/de-oil-ing | Solvent | - | - | Ion-ex-change water | Ion-ex-change water | Ion-ex-change water | Ion-ex-change water | Ion-ex-change water | Ion-ex-change water |
| | Temperature | - | °C | 60 | 60 | 60 | 60 | 60 | 60 |

(continued)

| | | Example 1 | Example 2 | Example 3 | Example 4 | Example 5 | Example 6 |
|---|---|---|---|---|---|---|---|
| Conditions of opening filament process and surface treatment process | Line speed | m/min | 20 | 20 | 20 | 20 | 20 | 20 |
| | Tension | N | 200 | 300 | 100 | 200 | 200 | 200 |
| | Opening filament process (E) after heating/de-oiling — Frequency | GHz | 25 | 25 | 25 | 25 | 25 | 25 |
| | Output | W/cm² | 0.72 | 0.72 | 0.72 | 0.72 | 0.72 | 0.72 |
| | Surface treatment process (F) — Drying temperature | °C | 125 | 125 | 125 | 125 | 125 | 125 |
| | Number of coatings | - | 2 | 2 | 2 | 2 | 1 | 2 |
| | Opening filament process (G) after surface treatment — High-pressure water spray | MPa | 1.4 | 1.4 | 1.4 | 1.4 | 1.4 | 1.4 |
| Substrate evaluation result | Number of CAF NG specimens | - | 1/10 | 1/10 | 1/10 | 2/10 | 3/10 | 3/10 |

[Table 4]

[Table 4]

Table 4

| | | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|
| Glass yarn | Compositional amount of $SiO_2$ | - | % | > 99.9 | > 99.9 | > 99.9 | > 99.9 | > 99.9 | > 99.9 | > 99.9 | 55 |
| | Single filament diameter (D) | Warp yarn | μm | 5.0 | 5.0 | 5.0 | 7.5 | 7.5 | 7.5 | 7.5 | 7.5 |
| | | Weft yarn | μm | 5.0 | 5.0 | 5.0 | 7.5 | 7.5 | 7.5 | 7.5 | 7.5 |
| | Number of filaments | Warp yarn | filaments | 100 | 200 | 100 | 44 | 44 | 44 | 44 | 44 |
| | | Weft yarn | filaments | 100 | 200 | 100 | 44 | 44 | 44 | 44 | 44 |
| Glass fabric | Thread count | Warp | filaments/inch | 66 | 54 | 66 | 66 | 66 | 66 | 66 | 66 |
| | | Weft | filaments/inch | 68 | 54 | 68 | 68 | 68 | 68 | 68 | 68 |
| | Value of loss of ignition | - | % | 0.11 | 0.12 | 0.12 | 0.11 | 0.10 | 0.10 | 0.10 | 0.15 |
| | Total amount of carbon | | % by weight | 0.10 | 0.11 | 0.11 | 0.10 | 0.09 | 0.09 | 0.09 | 0.14 |
| | Coefficient of variation in total amount of carbon | | % | 4 | 4 | 4 | 4 | 10 | 4 | 4 | 4 |
| | Nitrogen content | - | % by weight | < 0.004 | < 0.004 | < 0.004 | < 0.004 | < 0.004 | < 0.004 | < 0.004 | < 0.004 |
| | Air permeability | - | $cm^3/cm^2/sec$ | 25 | 50 | 20 | 210 | 210 | 216 | 204 | 120 |
| | Thickness (T) | - | μm | 30 | 46 | 30 | 30 | 30 | 31 | 30 | 30 |
| | Thickness × Air permeability | - | $cm^3/cm^2/sec \times$ μm | 750 | 2300 | 600 | 6300 | 6300 | 6696 | 6120 | 3600 |
| | 24.0 × D-T | - | μm | 90 | 74 | 90 | 150 | 150 | 149 | 150 | 150 |
| | Rate of decrease in desmear | - | % | 30 | 30 | 30 | 11 | 11 | 11 | 11 | 11 |

| | | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|
| Warping process (A) | Nip pressure | - | kg/cm$^2$ | 3.0 | 3.5 | 3.0 | 3.0 | 3.0 | - | 3.0 | 3.0 |
| Washing process (C) before heating/de-oiling | Solvent | - | - | Ion-exchange water | Ion-exchange water | Ion-exchange water | Ion-exchange water | Ion-exchange water | Ion-exchange water | - | Ion-exchange water |
| | Temperature | - | °C | 60 | 60 | 60 | 60 | 60 | 60 | - | 60 |
| Conditions of opening filament process and surface treatment process | Line speed | - | m/min | 20 | 20 | 20 | 20 | 20 | 20 | 20 | 20 |
| | Tension | - | N | 200 | 300 | 200 | 200 | 200 | 200 | 200 | 200 |
| | Opening filament process (E) after heating/de-oiling | Frequency | GHz | - | - | 25 | - | - | 25 | 25 | - |
| | | Output | W/cm$^2$ | - | - | 0.72 | - | - | 0.72 | 0.72 | - |
| | Surface treatment process (F) | Drying temperature | °C | 125 | 125 | 125 | 125 | 125 | 125 | 125 | 125 |
| | | Number of coatings | - | 2 | 2 | 2 | 2 | 1 | 2 | 2 | 2 |
| | Opening filament process (G) after surface treatment | High-pressure water spray | MPa | 1.4 | 1.4 | 1.4 | 1.4 | 1.4 | 1.4 | 1.4 | 1.4 |
| Substrate evaluation result | Number of CAF NG specimens | - | - | 8/10 | 8/10 | 7/10 | 5/10 | 6/10 | 5/10 | 5/10 | 2/10 |

EP 4 667 631 A1

**Claims**

1.  A glass fabric constituted from a warp yarn and a weft yarn, which are a glass yarn including a plurality of filaments, wherein the glass yarn has a silicon (Si) content of from 95.0 wt% to 100 wt% in terms of silicon dioxide ($SiO_2$), the filaments have an average single filament diameter (D) in a range of 4.5 $\mu$m to 9.0 $\mu$m, and a relationship between a thickness (T) of the glass fabric and the average single filament diameter (D) of the filaments satisfies the following formula (A1):

$$24.0 \times D - T > 96.0 \dots (A1);$$

and wherein a product of the thickness and air permeability of the glass fabric ($\mu$m·$cm^3$/$cm^2$/s) is in a range of 2500 to 6000.

2.  The glass fabric according to claim 1, wherein, when the glass fabric is immersed in a desmear solution and subjected to a surface treatment at 80°C for 2 hours, a rate of decrease in desmear of the average single filament diameter (D) of the filaments, represented by the following formula, is 25% or less:

    Rate of decrease in desmear = (Single filament diameter before desmear treatment - Single filament diameter after desmear treatment)/Single filament diameter before desmear treatment $\times$ 100.

3.  The glass fabric according to claim 1 or 2, wherein the glass fabric has air permeability in a range of 25 $cm^3$/$cm^2$/s to 350 $cm^3$/$cm^2$/s.

4.  The glass fabric according to claim 1 or 2, wherein the glass yarn is subjected to a surface treatment with a surface treatment agent.

5.  The glass fabric according to claim 4, wherein the surface treatment agent has a silane coupling agent having a structure represented by the following general formula (1):

    $$X(R)_{3-n}SiY_n \dots \qquad (1)$$

    in the formula (1), X is an organic group having one or more unsaturated double bond groups having radical reactivity, Y is each independently an alkoxy group, n is an integer of 1 to 3, and R is each independently at least one group selected from the group consisting of a methyl group, an ethyl group, and a phenyl group.

6.  The glass fabric according to claim 5, wherein X in the general formula (1) has a (meth)acryloyloxy group.

7.  The glass fabric according to claim 1 or 2, wherein the glass fabric has a value of loss of ignition in a range of 0.01 wt% to 0.50 wt%.

8.  The glass fabric according to claim 1 or 2, wherein the average number of filaments in the glass yarn is in a range of 20 to 200.

9.  The glass fabric according to claim 1 or 2, wherein a coefficient of variation in total amount of carbon, as obtained with gas chromatography of the glass fabric, is in a range of 15% or less.

10. The glass fabric according to claim 1 or 2, wherein a nitrogen content, as obtained with gas chromatography of the glass fabric, is less than 0.004 wt%.

11. A prepreg containing the glass fabric according to claim 1 or 2, and a matrix resin with which the glass fabric is impregnated.

12. The prepreg according to claim 11, further containing an inorganic filler.

13. A printed circuit board comprising the prepreg according to claim 11.

**14.** An integrated circuit comprising the printed circuit board according to claim 13.

**15.** An electronic device comprising the printed circuit board according to claim 13.

**16.** A method for producing a glass fabric, the method comprising:

weaving a glass yarn which includes a plurality of filaments and has a Si content in a range of 95.0 wt% to 100 wt% in terms of $SiO_2$, as each of a warp yarn and a weft yarn, to obtain a glass fabric, and
wherein the method further comprises, before the weaving process, a warping process of flattening and then sizing a yarn bundle of the glass yarn; and
wherein the method further comprises, after the warping process and before, during or after the weaving process, the following:

washing the glass yarn with water at 50°C or more;
heating/de-oiling and decreasing a binder attached to the glass yarn; and
irradiating the glass yarn heated/de-oiled, with ultrasound in a liquid, to open at least some of the glass filaments adhering by a residue of the binder after heating/de-oiling,

wherein the filaments have an average single filament diameter (D) in a range of 4.5 $\mu$m to 9.0 $\mu$m, and a relationship between a thickness (T) of the glass fabric and the average single filament diameter (D) of the filaments satisfies the following formula (A1):

$$24.0 \times D - T > 96.0 \ ... \ (A1).$$

**17.** The method according to claim 16, further comprising:

a surface treatment process of performing an operation including attaching a surface treatment agent to a surface of the filament-opened glass fabric and fixing the surface treatment agent to the surface of the glass fabric by heating and drying; and
opening at least some of the glass filaments adhering by the surface treatment agent.

## INTERNATIONAL SEARCH REPORT

| International application No. |
|---|
| **PCT/JP2023/044392** |

### A. CLASSIFICATION OF SUBJECT MATTER

*D03D 15/267*(2021.01)i; *C08J 5/24*(2006.01)i; *D03D 1/00*(2006.01)i; *D06M 13/513*(2006.01)i; *H05K 1/03*(2006.01)i
FI: D03D15/267; C08J5/24; D03D1/00 A; D06M13/513; H05K1/03 610T

According to International Patent Classification (IPC) or to both national classification and IPC

### B. FIELDS SEARCHED

Minimum documentation searched (classification system followed by classification symbols)

D03D1/00-27/18; B29B11/16; B29B15/08-15/14; C08J5/04-5/10; C08J5/24; D06M13/00-15/715; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2018-127747 A (ASAHI KASEI KABUSHIKI KAISHA) 16 August 2018 (2018-08-16) example 1 | 1-17 |
| A | JP 2009-263824 A (SHIN-ETSU QUARTZ PRODUCTS CO., LTD.) 12 November 2009 (2009-11-12) example 1 | 1-17 |
| A | WO 2017/018088 A1 (NITTO BOSEKI CO., LTD.) 02 February 2017 (2017-02-02) example 2 | 1-17 |
| A | JP 2010-31425 A (NITTO BOSEKI CO., LTD.) 12 February 2010 (2010-02-12) example 1 | 1-17 |

☐ Further documents are listed in the continuation of Box C.     ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **19 February 2024** | **27 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2023/044392**

| Patent document cited in search report | | | Publication date (day/month/year) | Patent family member(s) | | | Publication date (day/month/year) |
|---|---|---|---|---|---|---|---|
| JP | 2018-127747 | A | 16 August 2018 | US | 2018/0305846 | A1 | |
| | | | | examples 1-1 | | | |
| | | | | JP | 2018-127749 | A | |
| | | | | JP | 2018-127750 | A | |
| | | | | CN | 108411446 | A | |
| | | | | CN | 113235204 | A | |
| | | | | CN | 113337934 | A | |
| JP | 2009-263824 | A | 12 November 2009 | (Family: none) | | | |
| WO | 2017/018088 | A1 | 02 February 2017 | JP | 5831665 | B1 | |
| | | | | KR | 10-2017-0030091 | A | |
| | | | | CN | 107849760 | A | |
| | | | | TW | 201706470 | A | |
| | | | | HK | 1248288 | B | |
| JP | 2010-31425 | A | 12 February 2010 | (Family: none) | | | |

Form PCT/ISA/210 (patent family annex) (July 2022)

**EP 4 667 631 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023023775 A
- WO 2019065940 A
- WO 2019065941 A
- JP 2021063320 A
- JP 2005042245 A
- JP 2006063114 A